# EUROPEAN PATENT APPLICATION

(11) **EP 4 765 202 A1**
(43) Date of publication of application: **24.06.2026**
(21) Application number: 24854228.4
(22) Date of filing: 15.08.2024
(51) Int. Cl.: H01L 23/40, C09K 5/14

(54) **BONDING LAYER, HEAT TRANSFER DEVICE, AND PRODUCTION METHOD FOR BONDING LAYER**

(30) Priority: 17.08.2023 JP 2023132846
(71) Applicant: Tomoegawa Corporation, Tokyo 104-8335 (JP)
(72) Inventor: HASEGAWA, Makoto, Shizuoka-shi, Shizuoka 421-0192 (JP); MORIUCHI, Hideki, Shizuoka-shi, Shizuoka 421-0192 (JP)
(74) Representative: Hasegawa, Kan
(86) International application number: PCT/JP2024/029081
(87) International publication number: WO 2025/037640

(57) **Abstract**

A bonding layer 40 to be placed on a surface of a heat transfer body 20 includes an inorganic porous body 36 (including a fiber structure 30) and a bonding material 31. The inorganic porous body 36 is unevenly distributed such that, with respect to a plurality of cross-sections C₁ to C₅ extending parallel to the surface of the heat transfer body 20 at equal intervals, a cross-section where the inorganic porous body 36 is absent exists, or the bonding layer 40 includes a first layer having a first proportion as a proportion occupied by the inorganic porous body 36 in the bonding layer 40 and a second layer having a second proportion different from the first proportion as the proportion.

## Description

### TECHNICAL FIELD

The present disclosure relates to a bonding layer, a heat transfer device, and a production method for a bonding layer.

### BACKGROUND ART

Various types of heat transfer devices that dissipate heat generated by a heating element through a cooling member have been conventionally known. In such a heat transfer device, the heating element is joined to the cooling member by a bonding layer. As such a heat transfer device, Japanese Laid-Open Patent Publication No. 2022-024016 (JP2022-024016A) discloses a device capable of efficiently dissipating heat generated by a power semiconductor chip and suppressing an increase in thermal resistance caused by cracks occurring in solder.

### SUMMARY OF THE INVENTION

In conventional heat transfer devices, the positional relationship between an inorganic porous body such as inorganic fibers and a bonding material such as solder in the bonding layer has not been defined.

The present disclosure has been made in view of such circumstances, and an object of the present disclosure is to provide a novel bonding layer, a heat transfer device, and a production method for a bonding layer, in which the positional relationship between an inorganic porous body and a bonding material is defined.

A bonding layer of the present disclosure including:
an inorganic porous body; and
a bonding material, the bonding layer being a layer that is to be placed on a surface of a heat transfer body, wherein
the inorganic porous body is unevenly distributed such that, with respect to a plurality of cross-sections extending parallel to the surface of the heat transfer body at equal intervals, a cross-section where the inorganic porous body is absent exists, or the bonding layer includes a first layer having a first proportion as a proportion occupied by the inorganic porous body in the bonding layer and a second layer having a second proportion different from the first proportion as said proportion.

In the bonding layer of the present disclosure,
for a cross-section for which a ratio of the proportion to an average value of proportions occupied by the inorganic porous body in the bonding layer in the plurality of cross-sections is the smallest, said ratio may be in a range of 0 to 0.5.

Moreover, a thickness of the bonding layer in a direction orthogonal to the surface of the heat transfer body may be 10 µm to 200 µm.

Moreover, a ratio of the proportion in the cross-section where the inorganic porous body is in contact with the heat transfer body to the proportion in the cross-section located at a thickness position of 5 µm from the surface of the heat transfer body may be in a range of 0 to 0.8.

Moreover, an occupancy ratio of the inorganic porous body may be 25% to 95%.

Moreover, a ratio of an area where the inorganic porous body is in contact with the heat transfer body to an area where the bonding material is in contact with the heat transfer body may be 0.1 to 1.5.

Moreover, a heat transfer target body may be placed on a surface of the bonding layer opposite to a surface of the bonding layer on which the heat transfer body is placed, and
a ratio of an area where the inorganic porous body is in contact with the heat transfer target body to an area where the inorganic porous body is in contact with the heat transfer body may be 0.4 to 2.5.

Moreover, a thermal expansion coefficient at 100°C to 200°C may be 5 ppm/°C to 25 ppm/°C.

Moreover, a difference in linear expansion coefficient between the inorganic porous body and the bonding material at 100°C to 200°C may be 0.1 ppm/°C to 15 ppm/°C.

Moreover, the bonding material may be arranged in gaps in the inorganic porous body.

Moreover, the bonding material may be arranged in gaps in the inorganic porous body in part or all of the cross-sections where the inorganic porous body is present among the plurality of cross-sections.

Moreover, a ratio of a volume of the bonding material arranged in the gaps in the inorganic porous body to a volume of the bonding material in the bonding layer may be 0% to 80%.

Moreover, the bonding material arranged in the gaps in the inorganic porous body may be sintered to the inorganic porous body.

Moreover, the inorganic porous body may include inorganic fibers.

Moreover, the inorganic fibers may include copper fibers.

A heat transfer device of the present disclosure includes:
a heat transfer body; and
a bonding layer placed on a surface of the heat transfer body, wherein
the bonding layer includes
   an inorganic porous body, and
   a bonding material, and
the inorganic porous body is unevenly distributed such that, with respect to a plurality of cross-sections extending parallel to the surface of the heat transfer body at equal intervals, a cross-section where the inorganic porous body is absent exists, or the bonding layer includes a first layer having a first proportion as a proportion occupied by the inorganic porous body in the bonding layer and a second layer having a second proportion different from the first proportion as said proportion.

A production method for a bonding layer of the present disclosure is a production method for a bonding layer to be placed on a surface of a heat transfer body and includes the steps of:
placing an inorganic porous body on the surface of the heat transfer body;
melting a bonding material and supplying the molten bonding material to a surface of the inorganic porous body; and
cooling the bonding material.

Moreover, the step of melting the bonding material and supplying the molten bonding material to the surface of the inorganic porous body may include applying the molten bonding material to the surface of the inorganic porous body.

Moreover, the step of melting the bonding material and supplying the molten bonding material to the surface of the inorganic porous body may include impregnating an interior of the inorganic porous body with the molten bonding material.

Moreover, after the step of cooling the bonding material,
another bonding material different from the bonding material may be placed on a surface of the cooled bonding material.

A production method for a bonding layer of the present disclosure is a production method for a bonding layer to be placed on a surface of a heat transfer body and includes the steps of:
placing a bonding material on the bonding layer;
placing an inorganic porous body on a surface of the bonding material;
melting another bonding material different from the bonding material and supplying the molten other bonding material to a surface of the inorganic porous body; and
cooling the other bonding material.

### BRIEF DESCRIPTION OF THE DRAWINGS

FIG. 1A is a longitudinal cross-sectional view schematically showing a configuration of a heat transfer device according to an embodiment of the present disclosure.
FIG. 1B is a diagram for describing a cross-section C₆ of the heat transfer device shown in FIG. 1.
FIG. 2 is a longitudinal cross-sectional view schematically showing another configuration of the heat transfer device according to the embodiment of the present disclosure.
FIG. 3 is a longitudinal cross-sectional view schematically showing still another configuration of the heat transfer device according to the embodiment of the present disclosure.
FIG. 4 is a longitudinal cross-sectional view schematically showing still another configuration of the heat transfer device according to the embodiment of the present disclosure.
FIG. 5 is a longitudinal cross-sectional view schematically showing still another configuration of the heat transfer device according to the embodiment of the present disclosure.
FIG. 6 is a longitudinal cross-sectional view schematically showing still another configuration of the heat transfer device according to the embodiment of the present disclosure.
FIG. 7 is a longitudinal cross-sectional view schematically showing still another configuration of the heat transfer device according to the embodiment of the present disclosure.
FIG. 8 is a longitudinal cross-sectional view schematically showing still another configuration of the heat transfer device according to the embodiment of the present disclosure.
FIG. 9 is a longitudinal cross-sectional view schematically showing still another configuration of the heat transfer device according to the embodiment of the present disclosure.

### DETAILED DESCRIPTION

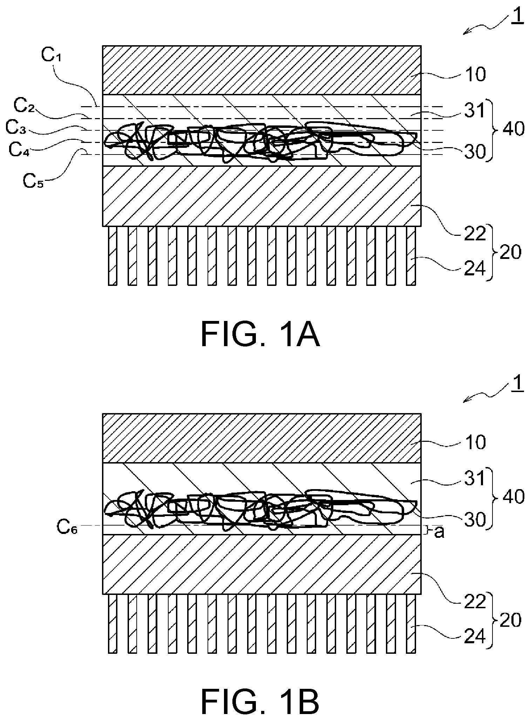

Hereinafter, an embodiment of the present disclosure will be described with reference to the drawings. FIG. 1A, FIG. 1B, and FIG. 2 to FIG. 9 are longitudinal cross-sectional views schematically showing various configurations of a heat transfer device according to the present embodiment. In the heat transfer device of the present embodiment, a bonding layer for joining a heat transfer target body, to which heat transfer is to be performed, and a heat transfer body includes an inorganic porous body and a bonding material, and the inorganic porous body is unevenly distributed in the width direction of the bonding layer. The inorganic porous body being unevenly distributed in the width direction of the bonding layer means that the inorganic porous body is not uniformly distributed in the width direction of the bonding layer. Specifically, this includes:
the inorganic porous body being locally distributed along the width direction of the bonding layer;
the inorganic porous body being arranged non-uniformly across the width of the bonding layer;
the distribution of the inorganic porous body in the width direction of the bonding layer being uneven;
the position of the inorganic porous body in the width direction of the bonding layer being not uniform; and
the inorganic porous body being concentrated in a specific region along the width of the bonding layer.

Furthermore, although the application field of the bonding structure in the heat transfer device of the present embodiment is not limited, the bonding structure can be used for joining materials having different linear expansion coefficients. Examples include power semiconductor elements, LED elements, laser diodes, and mounting substrates therefor; semiconductor devices; LED modules; semiconductor lasers; semiconductor manufacturing equipment; electrostatic chucks; heat exchangers; heaters; and the like.

A heat transfer device 1 shown in FIG. 1A includes a heat transfer body 20 and a bonding layer 40 for joining a heat transfer target body 10 to the heat transfer body 20, and the heat transfer target body 10 such as a semiconductor is joined to the heat transfer body 20 by the bonding layer 40. When the heat transfer target body 10 is placed on the upper surface of the bonding layer 40, the heat transfer target body 10 is cooled or heated by the heat transfer body 20 through the bonding layer 40. In the present embodiment, a heat sink (cooling member) is used as the heat transfer body 20, and a mode in which the heat transfer target body 10 is cooled through the bonding layer 40 by the heat sink will be described. However, in another mode, a heating member may be used as the heat transfer body 20, and the heat transfer target body 10 may be heated through the bonding layer 40 by the heating member.

The heat transfer body 20 includes a base 22 and rod-shaped or plate-shaped protruding members 24 which protrude from the surface of the base 22 in a direction orthogonal to the surface, and a fluid composed of a liquid or gas, such as a refrigerant, flows between the protruding members 24. Accordingly, the heat transfer body 20 is cooled, and thus heat transfer from the heat transfer target body 10 placed on the upper surface of the bonding layer 40 to the heat transfer body 20 is performed through the bonding layer 40.

The bonding layer 40 includes a fiber structure 30 as the inorganic porous body and a bonding material 31. In the heat transfer device 1 shown in FIG. 1A, the fiber structure 30 is included in the inorganic porous body. That is, many pores are present between inorganic fibers in the fiber structure 30, and thus the fiber structure 30 can be regarded as the inorganic porous body. In the heat transfer device 1 shown in FIG. 1A, an inorganic porous body other than the fiber structure 30 (e.g., a body obtained by densely packing metal particles or a bulk metal body including voids) may be used as the inorganic porous body included in the bonding layer 40.

As the bonding material 31, for example, metal materials such as solder and a brazing material, a metal paste, a thermally conductive resin sheet, etc., are used. When the bonding material 31 is composed of, for example, a metal material such as solder, the melting point of the bonding material 31 is, for example, about 300°C. When the bonding material 31 is composed of a metal paste or a thermally conductive resin sheet, a production step of vaporizing contained organic substances (such as a solvent) to obtain a bonding layer may be included.

The fiber structure 30 includes inorganic fibers such as copper fibers, and the bonding material 31 is arranged in gaps in the fiber structure 30 (specifically, in the gaps between the inorganic fibers). When the fiber structure 30 is composed of, for example, copper fibers, the melting point of the fiber structure 30 is, for example, about 1,100°C, which is higher than the melting point of the bonding material 31. As the inorganic fibers, fibers other than metal fibers such as copper fibers may also be used. When copper fibers are used as the inorganic fibers, the thermal conductivity of the fiber structure 30 can be improved. In such a fiber structure 30, the inorganic fibers such as copper fibers may be directly fixed to each other, or the inorganic fibers may be fixed to each other by a second inorganic component having a composition different from that of the inorganic fibers, or the like. In addition, the bonding material 31 arranged in the gaps in the fiber structure 30 may be connected to the inorganic fibers of the fiber structure 30 by sintering or the like. Moreover, the ratio of the volume of the bonding material 31 arranged in the gaps in the fiber structure 30 to the volume of the bonding material 31 in the bonding layer 40 is 0% to 80%. Here, in the mode shown in FIG. 1, the inorganic fibers constituting the fiber structure 30 are not in contact with each of the heat transfer target body 10 and the heat transfer body 20. The ratio of the volume of the bonding material 31 arranged in the gaps in the fiber structure 30 to the volume of the bonding material 31 in the bonding layer 40 is calculated from the true specific gravities of the bonding material 31 and the fiber structure 30. The true specific gravities of the bonding material 31 and the fiber structure 30 refer to the specific gravities of the bonding material 31 and the fiber structure 30 themselves without voids, respectively.

The average fiber diameter of the inorganic fibers can be arbitrarily set within a range that does not hinder the formation of a nonwoven fabric, but is preferably 1 µm to 100 µm, 2 µm to 100 µm, 5 µm to 100 µm, more preferably 10 µm to 100 µm, and further preferably 10 µm to 80 µm. When the average fiber diameter of the inorganic fibers is within the above range, both thermal stress relaxation properties and thermal conductivity of the bonding layer can be achieved. A combination of two types of inorganic fibers having different average fiber diameters may also be used. The average fiber diameter of one type of inorganic fibers may be 1 µm to 40 µm, 5 µm to 30 µm, 10 µm to 25 µm, or 10 µm to 20 µm, and the average fiber diameter of the other type of inorganic fibers may be 10 µm to 100 µm, 20 µm to 100 µm, or 40 µm to 100 µm. These inorganic fibers may be used in a mixed state or separately. When the average fiber diameter of the inorganic fibers is within the above range, so-called fiber clumping of the inorganic fibers is less likely to occur when forming a nonwoven fabric, and shape-following properties can be imparted to the fiber structure 30. The ratio of the thickness of the bonding layer 31 to the average fiber diameter of the inorganic fibers may be 1 to 200, 1 to 100, 1 to 50, 1 to 20, 1 to 10, or 1 to 5. When the ratio of the thickness of the bonding layer 31 to the average fiber diameter of the inorganic fibers is within the above range, the thermal conductivity in the thickness direction of the bonding layer 31 is improved. The cross-sectional shape of the inorganic fibers may be a circular shape, an elliptical shape, a substantially quadrangular shape, an irregular shape, or the like, but at least inorganic fibers having a circular cross-section are preferably included. Inorganic fibers having a circular cross-section tend to bend (form bent portions) more easily under stress than, for example, fibers having a prismatic cross-section, and differences in the degree of bending of the inorganic fibers are less likely to occur at the locations subjected to stress, so that the degree of bending tends to be made uniform. When inorganic fibers having bent portions are moderately entangled with each other, shape-following properties and cushioning properties tend to be enhanced. Here, the circular cross-section does not need to be a perfect circular cross-section and may have any circular cross-sectional shape in which moderate bent portions are easily formed under stress received during normal production of the fiber structure 30. In this specification, the term "average fiber diameter" refers to the average value of area-equivalent diameters obtained by calculating the cross-sectional areas of the inorganic fibers based on vertical cross-sections at arbitrary locations of the fiber structure 30 imaged with a microscope (e.g., using known software) and then calculating the diameters of circles having the same areas as the above cross-sectional areas (e.g., an average value for 20 fibers).

The fiber length of the inorganic fibers is preferably in the range of 0.01 mm to 20.0 mm, more preferably 0.01 mm to 10.0 mm, and further preferably 0.1 mm to 5.0 mm. When the average fiber length is within the above range, for example, both thermal stress relaxation properties and uniform thermal conductivity can be achieved. In addition, when producing the fiber structure 30 of the present embodiment by papermaking, so-called fiber clumping of the inorganic fibers is less likely to occur, an effect of making it easier to appropriately adjust dispersion can be expected, and an effect of improving sheet strength due to entanglement of the inorganic fibers is also easily exhibited. The fiber structure 30 is not particularly limited, and examples thereof include a nonwoven fabric, a woven fabric, and a mesh, and a nonwoven fabric is preferred from the viewpoint of stress relaxation. The nonwoven fabric may be produced by a wet papermaking method, a dry papermaking method, or a spunbond method. In this specification, the "average fiber length" refers to a value obtained by measuring, for example, 20 fibers under a microscope and calculating the average of those measurements. The term "papermaking" refers to forming raw materials into paper or the like.

Here, the thermal conductivity of the bonding layer 40 can be measured using the laser flash method, the temperature wave analysis method, or the like. For example, the bonding layer 40 may be cut into a predetermined size, and the thermal conductivity of the bonding layer 40 may be measured using a thermal diffusivity and thermal conductivity measuring apparatus (ai-Phase Mobile M3, manufactured by ai-Phase Co., Ltd.). Alternatively, a converted value obtained by comparing and converting a value obtained by this measurement method with values obtained by measuring standard samples of copper material C1020, aluminum material A1050, and stainless steel material SUS304, whose thermal conductivities are known, may be used.

As shown in FIG. 1A, the fiber structure 30 is unevenly present in the width direction of the bonding layer 40. Specifically, the fiber structure 30 is present in a lower region of the bonding layer 40 but not in an upper region of the bonding layer 40. That is, with respect to a plurality of cross-sections extending, at equal intervals, parallel to the surface of the heat transfer body 20 on which the bonding layer 40 is placed, a cross-section where the fiber structure 30 is absent exists. In FIG. 1A, five cross-sections C₁ to C₅ are illustrated as the plurality of cross-sections extending, at equal intervals, parallel to the surface of the heat transfer body 20 on which the bonding layer 40 is placed. Here, the distances between the respective cross-sections C₁ to C₅, the distance between the cross-section C₅ and the heat transfer body 20, and the distance between the cross-section C₁ and the heat transfer target body 10 are the same. As shown in FIG. 1, the fiber structure 30 is present in the cross-sections C₃ to C₅, but the fiber structure 30 is absent in the cross-sections C₁ and C₂. In addition, in one or more or all of the cross-sections C₃ to C₅ where the fiber structure 30 is present among the plurality of cross-sections, the bonding material 31 is arranged in the gaps in the fiber structure 30.

Moreover, in such a bonding layer 40, for a cross-section (e.g., the cross-sections C₁ and C₂) for which the ratio of the proportion occupied by the fiber structure 30 in the bonding layer 40 to the average value of the proportions occupied by the fiber structure 30 in the bonding layer 40 in the plurality of cross-sections C₁ to C₅ extending parallel to the surface of the heat transfer body 20 at equal intervals is the smallest, this ratio is in the range of 0 to 0.5 (in the mode shown in FIG. 1, this ratio is 0). Accordingly, the fiber structure 30 is unevenly present in the width direction of the bonding layer 40.

The number of cross-sections extending, at equal intervals, parallel to the surface of the heat transfer body 20 on which the bonding layer 40 is placed is not limited to five. The number of cross-sections may be any number up to a predetermined threshold, such as three, four, eight, ten, or twenty.

Moreover, as shown in FIG. 1B, a ratio of the proportion occupied by the fiber structure 30 in contact with the surface of the heat transfer body 20 to the proportion occupied by the fiber structure 30 in a cross-section C6 located at a thickness position of 5 µm (indicated by reference character "a" in FIG. 1B) from the surface of the heat transfer body 20 is in the range of 0 to 0.8. Thus, in the bonding layer 40 shown in FIG. 1B, the fiber structure 30 is not in a dense state near the surface of the heat transfer body 20.

Moreover, the thickness of the bonding layer 40 in the direction orthogonal to the surface of the heat transfer body 20 on which the bonding layer 40 is placed is 10 µm to 200 µm. The occupancy ratio of the fiber structure 30 in the bonding layer 40 is 25% to 95%, more preferably 25% to 90%, and further preferably 35% to 80%. When the occupancy ratio of the fiber structure 30 in the bonding layer 40 is within the above range, both stress relaxation properties and good thermal conductivity can be achieved. In addition, since a sufficient amount of the inorganic fibers is ensured, thermal conductivity can be maintained, and shape-following properties can be imparted. In this specification, the occupancy ratio refers to the proportion of portions where the inorganic fibers are present with respect to the volume of the bonding layer 40, and is also the proportion of the inorganic fibers with respect to the total of the volumes of the inorganic fibers and voids in the fiber structure 30. The ratio of the area occupied by the inorganic fibers to the area of the interior of the outer edge of the bonding layer 40 in a cut surface obtained when the bonding layer 40 is cut, is defined as the occupancy ratio. The bonding layer 40 has a thermal expansion coefficient of 5 ppm/°C to 25 ppm/°C at 100°C to 200°C. The difference in linear expansion coefficient between the fiber structure 30 and the bonding material 31 at 100°C to 200°C is 0.1 ppm/°C to 15 ppm/°C.

Next, a production method for such a heat transfer device 1 will be described. First, the bonding material 31 is melted, and the molten bonding material 31 is applied to the surface of the heat transfer body 20. Next, the bonding material 31 is cooled and solidified. Thus, a thin layer or film of the bonding material 31 is formed on the surface of the heat transfer body 20. Then, the fiber structure 30 is placed on the surface of the thin layer or film of the solidified bonding material 31. Here, the fiber structure 30 to be placed on the surface of the bonding material 31 is obtained by connecting the inorganic fibers such as copper fibers to each other by sintering or the like. Next, a new bonding material 31 is melted, and the molten bonding material 31 is supplied to the surface of the fiber structure 30. Accordingly, a part of the molten bonding material 31 enters the gaps between the inorganic fibers in the fiber structure 30, and the bonding material 31 that has entered the gaps is connected to the inorganic fibers of the fiber structure 30. Next, the bonding material 31 is cooled and solidified. Thus, a layer composed of the fiber structure 30 and the bonding material 31 is formed. Here, when a metal paste is used as the bonding material 31, since the metal paste is liquid, a production step of melting is not necessary, and instead, by adding a production step of vaporizing contained organic substances and sintering metal powders, the bonding layer 40 can be formed. More specifically, since the metal paste contains organic substances and the metal powders are separated from each other, a step of vaporizing the organic substances and sintering the metal powders is necessary. Furthermore, a new bonding material 31 is melted, and the molten bonding material 31 is supplied to the surface of the layer composed of the fiber structure 30 and the bonding material 31. Next, the bonding material 31 is cooled and solidified. Finally, the heat transfer target body 10 is placed on the bonding layer 40. Thus, the heat transfer device 1 shown in FIG. 1 is obtained.

According to the bonding layer 40 and the heat transfer device 1 shown in FIG. 1A and FIG. 1B, the fiber structure 30 is unevenly distributed near the heat transfer body 20. Therefore, compared to a configuration in which a fiber structure is uniformly present throughout a bonding layer, thermal conductivity can be improved and stress relaxation properties can also be improved.

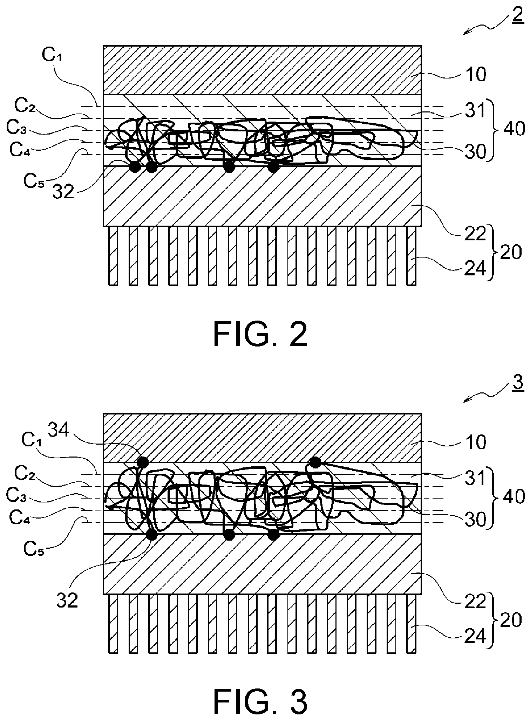

The heat transfer device according to the present embodiment is not limited to the heat transfer device shown in FIG. 1A and FIG. 1B. As the heat transfer device, a heat transfer device shown in FIG. 2 may be used. A heat transfer device 2 shown in FIG. 2 differs from the heat transfer device 1 shown in FIG. 1 in that some of the inorganic fibers constituting the fiber structure 30 of the bonding layer 40 are in contact with the heat transfer body 20, and the other configuration thereof is substantially the same as that of the heat transfer device 1 shown in FIG. 1. In describing the configuration of the heat transfer device 2 shown in FIG. 2, the description of components that are substantially the same as those of the heat transfer device 1 shown in FIG. 1 is omitted.

In the heat transfer device 2 shown in FIG. 2 as well, the fiber structure 30 is unevenly present in the width direction of the bonding layer 40. Specifically, the fiber structure 30 is present in a lower region of the bonding layer 40 but not in an upper region of the bonding layer 40. That is, with respect to a plurality of cross-sections extending, at equal intervals, parallel to the surface of the heat transfer body 20 on which the bonding layer 40 is placed, a cross-section where the fiber structure 30 is absent exists. **In** FIG. 2, five cross-sections C₁ to C₅ are illustrated as the plurality of cross-sections extending, at equal intervals, parallel to the surface of the heat transfer body 20 on which the bonding layer 40 is placed. Here, the distances between the respective cross-sections C₁ to C₅, the distance between the cross-section C₅ and the heat transfer body 20, and the distance between the cross-section C₁ and the heat transfer target body 10 are the same. As shown in FIG. 2, the fiber structure 30 is present in the cross-sections C₃ to C₅, but the fiber structure 30 is absent in the cross-sections C₁ and C₂. In addition, in one or more or all of the cross-sections C₃ to C₅ where the fiber structure 30 is present among the plurality of cross-sections, the bonding material 31 is arranged in the gaps in the fiber structure 30.

As shown in FIG. 2, some of the inorganic fibers constituting the fiber structure 30 are in contact with the heat transfer body 20 at locations indicated by reference character 32. Accordingly, compared to the heat transfer device 1 shown in FIG. 1, the thermal conductivity of the bonding layer 40 can be improved. In addition, some of the inorganic fibers constituting the fiber structure 30 are not sintered to the heat transfer body 20 at the locations indicated by reference character 32, and the locations where some of the inorganic fibers constituting the fiber structure 30 are in contact with the heat transfer body 20 change when the heat transfer body 20 or the bonding layer 40 expands or contracts. Accordingly, when the heat transfer body 20 undergoes thermal expansion or thermal contraction, the fiber structure 30 does not follow the heat transfer body 20, and thus the occurrence of problems such as cracking between the heat transfer body 20 and the bonding layer 40 can be suppressed.

Moreover, in the heat transfer device 2 shown in FIG. 2, the ratio of the area where the fiber structure 30 is in contact with the heat transfer body 20 to the area where the bonding material 31 is in contact with the heat transfer body 20 is 0.1 to 1.5. When the ratio of the area where the fiber structure 30 is in contact with the heat transfer body 20 to the area where the bonding material 31 is in contact with the heat transfer body 20 is 0.1 to 1.5, the fiber structure 30 can be prevented from being in a dense state on the surface of the heat transfer body 20, while ensuring sufficient thermal conductivity between the heat transfer body 20 and the bonding layer 40, and thus the heat transfer body 20 and the heat transfer target body 10 can be sufficiently joined by the bonding layer 40.

Next, a production method for such a heat transfer device 2 will be described. First, the fiber structure 30 is placed on the surface of the heat transfer body 20. Here, the fiber structure 30 to be placed on the surface of the heat transfer body 20 is obtained by sintering the inorganic fibers such as copper fibers to each other. Next, the bonding material 31 is melted, and the molten bonding material 31 is supplied to the surface of the fiber structure 30. Accordingly, a part of the molten bonding material 31 enters the gaps between the inorganic fibers in the fiber structure 30, and the bonding material 31 that has entered the gaps is connected to the inorganic fibers of the fiber structure 30. Next, the bonding material 31 is cooled and solidified. Thus, a layer composed of the fiber structure 30 and the bonding material 31 is formed. Furthermore, a new bonding material 31 is melted, and the molten bonding material 31 is supplied to the surface of the layer composed of the fiber structure 30 and the bonding material 31. Next, the bonding material 31 is cooled and solidified. Finally, the heat transfer target body 10 is placed on the bonding layer 40. Thus, the heat transfer device 2 shown in FIG. 2 is obtained.

According to the bonding layer 40 and the heat transfer device 2 shown in FIG. 2, the fiber structure 30 is unevenly distributed near the heat transfer body 20, and the fiber structure 30 is in contact with the heat transfer body 20. Therefore, compared to a configuration in which a fiber structure is uniformly present throughout a bonding layer, thermal conductivity can be improved and stress relaxation properties can also be improved. In addition, compared to the bonding layer 40 and the heat transfer device 1 shown in FIG. 1, thermal conductivity can be further improved.

As the heat transfer device, a heat transfer device shown in FIG. 3 may also be used. A heat transfer device 3 shown in FIG. 3 differs from the heat transfer device 2 shown in FIG. 2 in that some of the inorganic fibers constituting the fiber structure 30 of the bonding layer 40 are in contact with the heat transfer target body 10, and the other configuration thereof is substantially the same as that of the heat transfer device 2 shown in FIG. 2. In describing the configuration of the heat transfer device 3 shown in FIG. 3, the description of components that are substantially the same as those of the heat transfer device 2 shown in FIG. 2 is omitted.

As shown in FIG. 3, some of the inorganic fibers constituting the fiber structure 30 are in contact with the heat transfer target body 10 at locations indicated by reference character 34. Accordingly, compared to the heat transfer device 2 shown in FIG. 2, the thermal conductivity of the bonding layer 40 can be further improved. In addition, the locations where some of the inorganic fibers constituting the fiber structure 30 are in contact with the heat transfer target body 10 change when the heat transfer target body 10 or the bonding layer 40 expands or contracts. Accordingly, when the bonding layer 40 undergoes thermal expansion or thermal contraction, the heat transfer target body 10 does not follow the fiber structure 30, and thus the occurrence of problems such as cracking between the heat transfer target body 10 and the bonding layer 40 can be suppressed.

Moreover, in the heat transfer device 3 shown in FIG. 3, the ratio of the area where the fiber structure 30 is in contact with the heat transfer target body 10 to the area where the fiber structure 30 is in contact with the heat transfer body 20 is 0.4 to 2.5. In this case, the bonding layer 40 can exhibit sufficient thermal conductivity, and problems such as cracking between the heat transfer body 20 and the bonding layer 40 and between the heat transfer target body 10 and the bonding layer 40 can be prevented from occurring.

Next, a production method for such a heat transfer device 3 will be described. First, the fiber structure 30 is placed on the surface of the heat transfer body 20. Here, the fiber structure 30 to be placed on the surface of the heat transfer body 20 is obtained by sintering the inorganic fibers such as copper fibers to each other. Next, the bonding material 31 is melted, and the molten bonding material 31 is supplied to the surface of the fiber structure 30. Accordingly, a part of the molten bonding material 31 enters the gaps between the inorganic fibers in the fiber structure 30, and the bonding material 31 that has entered the gaps is connected to the inorganic fibers of the fiber structure 30. When supplying the molten bonding material 31 to the surface of the fiber structure 30, a part of the fiber structure 30 is exposed from the upper surface of the bonding material 31 to the outside. Next, the bonding material 31 is cooled and solidified. Thus, a layer composed of the fiber structure 30 and the bonding material 31 is formed. Finally, the heat transfer target body 10 is placed on the bonding layer 40. At this time, the heat transfer target body 10 is brought into contact with the fiber structure 30. Thus, the heat transfer device 3 shown in FIG. 3 is obtained.

According to the bonding layer 40 and the heat transfer device 3 shown in FIG. 3, the fiber structure 30 is in contact with the heat transfer body 20 and the heat transfer target body 10. Therefore, compared to a bonding layer in which a fiber structure is not in contact with a heat transfer body and a heat transfer target body, thermal conductivity can be improved.

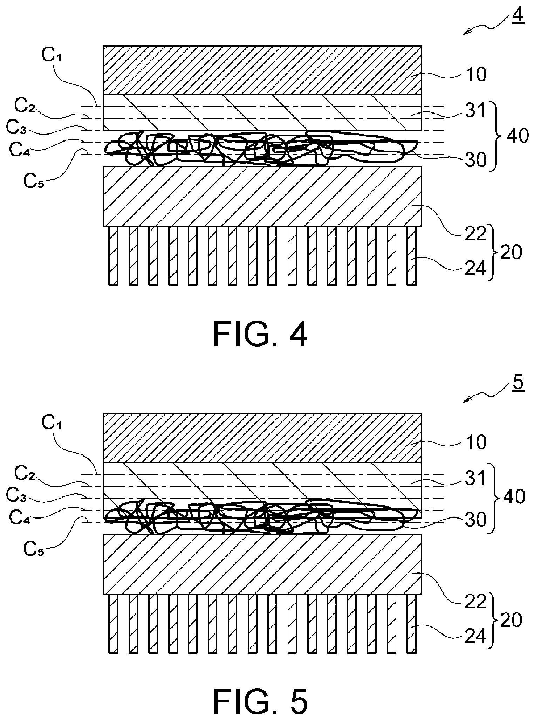

As the heat transfer device, a heat transfer device shown in FIG. 4 may also be used. A heat transfer device 4 shown in FIG. 4 differs from the heat transfer device 2 shown in FIG. 2 in that the bonding layer 40 is composed of the fiber structure 30 and the bonding material 31 but the bonding material 31 does not enter the gaps between the inorganic fibers constituting the fiber structure 30, and the other configuration thereof is substantially the same as that of the heat transfer device 2 shown in FIG. 2. In describing the configuration of the heat transfer device 4 shown in FIG. 4, the description of components that are substantially the same as those of the heat transfer device 2 shown in FIG. 2 is omitted.

In the heat transfer device 4 shown in FIG. 4, the bonding layer 40 is composed of two layers: a layer of the fiber structure 30 placed on a side closer to the heat transfer body 20 and a layer of the bonding material 31 placed on a side closer to the heat transfer target body 10. The inorganic fibers constituting the fiber structure 30 are in contact with the heat transfer body 20. In addition, the inorganic fibers constituting the fiber structure 30 are also connected to the bonding material 31. In this case, when the heat transfer body 20 undergoes thermal expansion or thermal contraction, the fiber structure 30 in which the inorganic fibers are in contact with the heat transfer body 20 also expands or contracts following the heat transfer body 20. Therefore, when the heat transfer body 20 undergoes thermal expansion or thermal contraction, the occurrence of problems such as cracking between the heat transfer body 20 and the bonding layer 40 can be suppressed.

In the heat transfer device 4 shown in FIG. 4, the bonding material 31 does not enter the gaps between the inorganic fibers of the fiber structure 30. In addition, as the bonding material 31, for example, metal materials such as solder and a brazing material, a metal paste, a thermally conductive resin sheet, etc., can be used. In this case, the melting point of the bonding material 31 is, for example, about 300°C. In addition, the metal material constituting the bonding material 31 and the metal that is the material of the inorganic fibers of the fiber structure 30 may be of the same type (e.g., copper).

Next, a production method for such a heat transfer device 4 will be described. First, the fiber structure 30 is placed on the surface of the heat transfer body 20. Here, the fiber structure 30 to be placed on the surface of the heat transfer body 20 is obtained by sintering the inorganic fibers such as copper fibers to each other. Next, the bonding material 31 is melted, and the molten bonding material 31 is applied to the surface of the fiber structure 30. Then, the applied bonding material 31 is cooled. At this time, some of the inorganic fibers constituting the fiber structure 30 are connected to the bonding material 31. Finally, the heat transfer target body 10 is placed on the bonding layer 40. Thus, the heat transfer device 4 shown in FIG. 4 is obtained.

According to the bonding layer 40 and the heat transfer device 4 shown in FIG. 4, the bonding layer 40 is composed of the two layers of the fiber structure 30 and the bonding material 31, and the fiber structure 30 is placed near the heat transfer body 20. Therefore, compared to a configuration in which a fiber structure is uniformly present throughout a bonding layer, thermal conductivity can be improved and stress relaxation properties can also be improved.

As the heat transfer device, a heat transfer device shown in FIG. 5 may also be used. A heat transfer device 5 shown in FIG. 5 differs from the heat transfer device 4 shown in FIG. 4 in that the bonding material 31 has entered a certain region of the fiber structure 30, and the other configuration thereof is substantially the same as that of the heat transfer device 4 shown in FIG. 4. In describing the configuration of the heat transfer device 5 shown in FIG. 5, the description of components that are substantially the same as those of the heat transfer device 4 shown in FIG. 4 is omitted.

In the heat transfer device 5 shown in FIG. 5, the bonding layer 40 is composed of two layers: a layer of the fiber structure 30 placed on a side closer to the heat transfer body 20 and a layer of the bonding material 31 placed on a side closer to the heat transfer target body 10, but a part of the bonding material 31 has entered the gaps between the inorganic fibers in a certain region of the fiber structure 30 (specifically, a region on the side farther from the heat transfer body 20). The inorganic fibers constituting the fiber structure 30 are connected to the bonding material 31 that has entered the gaps in the fiber structure 30.

Next, a production method for such a heat transfer device 5 will be described. First, the fiber structure 30 is placed on the surface of the heat transfer body 20. Here, the fiber structure 30 to be placed on the surface of the bonding material 31 is obtained by sintering the inorganic fibers such as copper fibers to each other. Next, the bonding material 31 is melted, and the molten bonding material 31 is applied to the surface of the fiber structure 30. At this time, a part of the molten bonding material 31 is allowed to enter the gaps between the inorganic fibers in the fiber structure 30. Then, the applied bonding material 31 is cooled. At this time, some of the inorganic fibers constituting the fiber structure 30 are connected to the bonding material 31. Finally, the heat transfer target body 10 is placed on the bonding layer 40. Thus, the heat transfer device 5 shown in FIG. 5 is obtained.

According to the bonding layer 40 and the heat transfer device 5 shown in FIG. 5, the bonding layer 40 is composed of two layers of the fiber structure 30 and the bonding material 31, and the fiber structure 30 is placed near the heat transfer body 20. Therefore, compared to a configuration in which a fiber structure is uniformly present throughout a bonding layer, thermal conductivity can be improved and stress relaxation properties can also be improved.

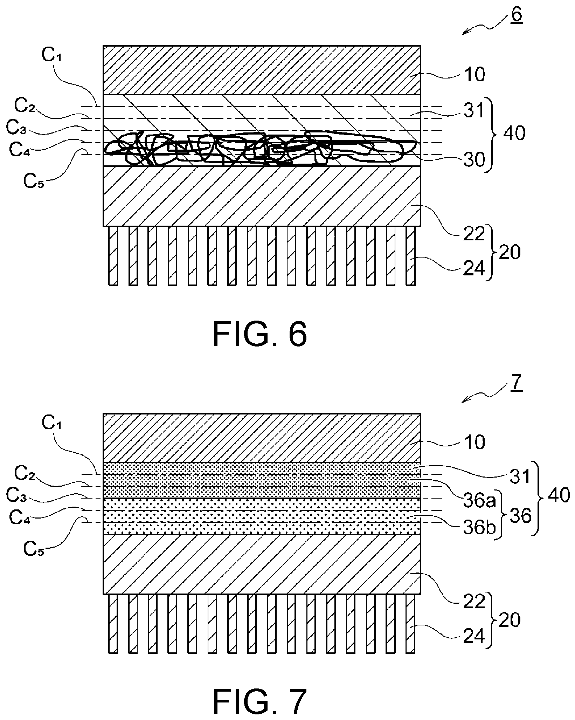

As the heat transfer device, a heat transfer device shown in FIG. 6 may also be used. A heat transfer device 6 shown in FIG. 6 differs from the heat transfer device 5 shown in FIG. 5 in that the bonding material 31 has entered all regions of the fiber structure 30, and the other configuration thereof is substantially the same as that of the heat transfer device 5 shown in FIG. 5. In describing the configuration of the heat transfer device 6 shown in FIG. 6, the description of components that are substantially the same as those of the heat transfer device 5 shown in FIG. 5 is omitted.

In the heat transfer device 6 shown in FIG. 6, a part of the bonding material 31 has entered the gaps between the inorganic fibers in all the regions of the fiber structure 30. The inorganic fibers constituting the fiber structure 30 are connected to the bonding material 31 that has entered the gaps in the fiber structure 30.

Next, a production method for such a heat transfer device 6 will be described. First, the fiber structure 30 is placed on the surface of the heat transfer body 20. Here, the fiber structure 30 to be placed on the surface of the heat transfer body 20 is obtained by sintering the inorganic fibers such as copper fibers to each other. Next, the bonding material 31 is melted, and the molten bonding material 31 is applied to the surface of the fiber structure 30. At this time, a part of the molten bonding material 31 is allowed to enter the gaps between the inorganic fibers in the fiber structure 30. In addition, the bonding material 31 is allowed to enter all the regions of the fiber structure 30 by pressing the molten bonding material 31 from above. Then, the applied bonding material 31 is cooled. At this time, some of the inorganic fibers constituting the fiber structure 30 are connected to the bonding material 31. Finally, the heat transfer target body 10 is placed on the bonding layer 40. Thus, the heat transfer device 6 shown in FIG. 6 is obtained.

According to the bonding layer 40 and the heat transfer device 6 shown in FIG. 6, the bonding layer 40 is composed of two layers of the fiber structure 30 and the bonding material 31, and the fiber structure 30 is placed near the heat transfer body 20. Therefore, compared to a configuration in which a fiber structure is uniformly present throughout a bonding layer, thermal conductivity can be improved and stress relaxation properties can also be improved.

As the heat transfer device, a heat transfer device shown in FIG. 7 may also be used. A heat transfer device 7 shown in FIG. 7 differs from the heat transfer device 1 shown in FIG. 1 in that, as the bonding layer 40, an inorganic porous body 36 such as a metallic porous body and the bonding material 31 are used instead of using the layer including the fiber structure 30 and the bonding material 31, and the other configuration thereof is substantially the same as that of the heat transfer device 1 shown in FIG. 1. In describing the configuration of the heat transfer device 7 shown in FIG. 7, the description of components that are substantially the same as those of the heat transfer device 1 shown in FIG. 1 is omitted.

In the heat transfer device 7 shown in FIG. 7, a body having a structure in which fine inorganic fiber particles such as fine metal fiber particles are densely packed is used as the inorganic porous body 36 such as a metallic porous body. Here, the inorganic porous body 36 is composed of a first layer 36a and a second layer 36b, the first layer 36a is placed on the heat transfer target body 10 side, and the second layer 36b is placed on the heat transfer body 20 side. In addition, the bonding material 31 has entered the gaps between the inorganic fibers in the first layer 36a of the fiber structure 30 and the gaps between the inorganic fibers in the second layer 36b. In another mode, the bonding material 31 may not necessarily have entered the gaps between the inorganic fibers in the first layer 36a of the inorganic porous body 36 and the gaps between the inorganic fibers in the second layer 36b.

Here, the first layer 36a has a structure in which inorganic fiber particles such as fine metal fiber particles (e.g., copper fiber particles) are densely packed. As such inorganic fiber particles, for example, copper fiber particles having a diameter of 10 µm and a length of 100 µm are used. Such a first layer 36a is characterized by excellent thermal conductivity but poor stress relaxation properties. In addition, the second layer 36b has a structure in which inorganic fiber particles such as metal fiber particles (e.g., copper fiber particles) are deposited in a state ranging from sparse to dense. As such inorganic fiber particles, for example, copper fiber particles having a diameter of 18.5 µm and a length of 3,000 µm are used. Such a first layer 36b is characterized by poor thermal conductivity but excellent stress relaxation properties.

In the heat transfer device 7 shown in FIG. 7, the inorganic porous body 36 is unevenly distributed such that, with respect to a plurality of cross-sections C₁ to C₅ extending parallel to the surface of the heat transfer body 20 at equal intervals, the bonding layer 40 includes the first layer 36a having a first proportion as the proportion occupied by the inorganic porous body 36 in the bonding layer 40 and the second layer 36b having a second proportion different from the first proportion as this proportion. In this case, the inorganic porous body 36 is composed of the two layers 36a and 36b having different occupancy ratios in the bonding layer 40 to incorporate the advantages of both layers therein, and thus can have excellent thermal conductivity and stress relaxation properties.

Moreover, for the cross-sections C₄ and C₅ for which the ratio of the proportion occupied by the inorganic porous body 36 in the bonding layer 40 to the average value of the proportions occupied by the inorganic porous body 36 in the bonding layer 40 in the plurality of cross-sections C₁ to C₅ is the smallest, this ratio is in the range of 0 to 0.45. In this case, the inorganic porous body 36 can be more reliably distributed unevenly in the bonding layer 40.

Next, a production method for such a heat transfer device 7 will be described. First, the second layer 36b of the inorganic porous body 36 is placed on the surface of the heat transfer body 20. The second layer 36b has a relatively small occupancy ratio of inorganic fiber particles. As such inorganic fiber particles, for example, copper fiber particles having a diameter of 18.5 µm and a length of 3,000 µm are used. Next, the bonding material 31 is melted, and the molten bonding material 31 is applied to the surface of the second layer 36b of the inorganic porous body 36. Accordingly, the molten bonding material 31 enters the gaps between the inorganic fiber particles in the inorganic porous body 36, and the bonding material 31 that has entered the gaps is connected to the inorganic fiber particles of the second layer 36b of the inorganic porous body 36. Next, the bonding material 31 is cooled and solidified. Then, the first layer 36a of the inorganic porous body 36 is placed on the surface of the solidified bonding material 31. The first layer 36a has a relatively great occupancy ratio of inorganic fiber particles. As such inorganic fiber particles, for example, copper fiber particles having a diameter of 10 µm and a length of 100 µm are used. When placing the first layer 36a of the inorganic porous body 36 on the surface of the solidified bonding material 31, some of the inorganic fiber particles constituting the first layer 36a are sintered to the second layer 36b by performing heating. Next, the bonding material 31 is melted, and the molten bonding material 31 is applied to the surface of the first layer 36a of the inorganic porous body 36. Accordingly, the molten bonding material 31 enters the gaps between the inorganic fiber particles in the inorganic porous body 36, and the bonding material 31 that has entered the gaps is connected to the inorganic fiber particles of the first layer 36a of the inorganic porous body 36. Then, the bonding material 31 is cooled and solidified. Finally, the heat transfer target body 10 is placed on the bonding layer 40. Thus, the heat transfer device 7 shown in FIG. 7 is obtained.

In the bonding layer 40 and the heat transfer device 7 shown in FIG. 7, the inorganic porous body 36 is unevenly distributed in the bonding layer 40. Specifically, the inorganic porous body 36 is composed of the two layers 36a and 36b having different occupancy ratios in the bonding layer 40 to incorporate the advantages of both layers therein. Therefore, the bonding layer 40 can have excellent thermal conductivity and stress relaxation properties.

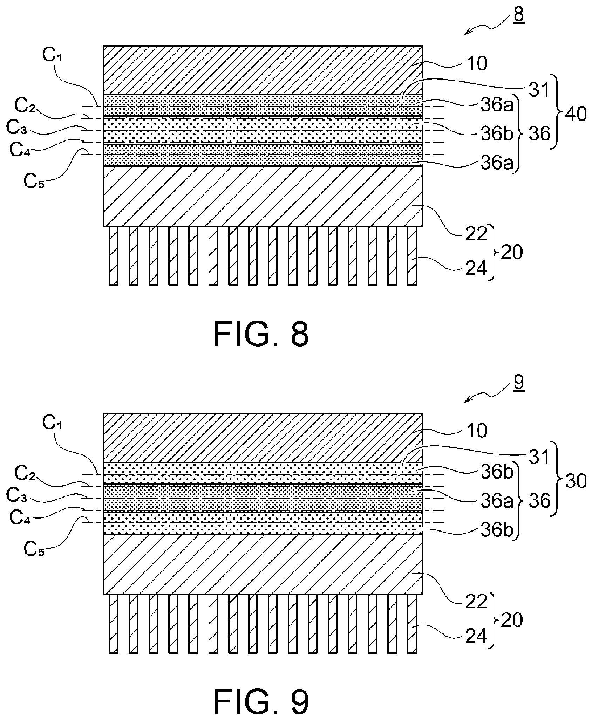

As the heat transfer device, a heat transfer device shown in FIG. 8 may also be used. A heat transfer device 8 shown in FIG. 8 differs from the heat transfer device 7 shown in FIG. 7 in that the inorganic porous body 36 constituting the bonding layer 40 is composed of three layers: two first layers 36a having a relatively great occupancy ratio of inorganic fiber particles and a second layer 36b placed between the two first layers 36a and having a smaller occupancy ratio of inorganic fiber particles than the first layers 36a, and the other configuration thereof is substantially the same as that of the heat transfer device 7 shown in FIG. 7. In describing the configuration of the heat transfer device 8 shown in FIG. 8, the description of components that are substantially the same as those of the heat transfer device 7 shown in FIG. 7 is omitted.

As shown in FIG. 8, the inorganic porous body 36 is composed of the two first layers 36a and the second layer 36b placed between the respective first layers 36a, one first layer 36a is placed on the heat transfer target body 10 side, and the other first layer 36a is placed on the heat transfer body 20 side. In addition, the bonding material 31 has entered the gaps between the inorganic fiber particles in each first layer 36a of the inorganic porous body 36 and the gaps between the inorganic fiber particles in the second layer 36b. In another mode, the bonding material 31 may not necessarily have entered the gaps between the inorganic fibers in each first layer 36a of the inorganic porous body 36 and the gaps between the inorganic fibers in the second layer 36b.

In the heat transfer device 8 shown in FIG. 8, the inorganic porous body 36 is unevenly distributed such that, with respect to a plurality of cross-sections C₁ to C₅ extending parallel to the surface of the heat transfer body 20 at equal intervals, the bonding layer 40 includes the first layers 36a having a first proportion as the proportion occupied by the inorganic porous body 36 in the bonding layer 40 and the second layer 36b having a second proportion different from the first proportion as this proportion. In this case, the inorganic porous body 36 is composed of the three layers 36a, 36b, and 36a having different occupancy ratios in the bonding layer 40 to incorporate the advantages of both types of layers therein, and thus can have excellent thermal conductivity and stress relaxation properties.

Moreover, for the cross-section C₃ for which the ratio of the proportion occupied by the inorganic porous body 36 in the bonding layer 40 to the average value of the proportions occupied by the inorganic porous body 36 in the bonding layer 40 in the plurality of cross-sections C₁ to C₅ is the smallest, this ratio is in the range of 0 to 0.5. In this case, the inorganic porous body 36 can be more reliably distributed unevenly in the bonding layer 40.

A production method for such a heat transfer device 8 is similar to the production method for the heat transfer device 7 shown in FIG. 7, and thus the description thereof is omitted.

In the bonding layer 40 and the heat transfer device 8 shown in FIG. 8, the inorganic porous body 36 is unevenly distributed in the bonding layer 40. Specifically, the inorganic porous body 36 is composed of the three layers 36a, 36b, and 36a having different occupancy ratios in the bonding layer 40 to incorporate the advantages of both types of layers therein. Therefore, the bonding layer 40 can have excellent thermal conductivity and stress relaxation properties.

As the heat transfer device, a heat transfer device shown in FIG. 9 may also be used. A heat transfer device 9 shown in FIG. 9 differs from the heat transfer device 7 shown in FIG. 7 in that the inorganic porous body 36 constituting the bonding layer 40 is composed of three layers: two second layers 36b having a relatively small occupancy ratio of inorganic fiber particles and a first layer 36a placed between the two second layers 36b and having a greater occupancy ratio of inorganic fibers than the second layer 36b, and the other configuration thereof is substantially the same as that of the heat transfer device 7 shown in FIG. 7. In describing the configuration of the heat transfer device 9 shown in FIG. 9, the description of components that are substantially the same as those of the heat transfer device 7 shown in FIG. 7 is omitted.

As shown in FIG. 9, the inorganic porous body 36 is composed of the two second layers 36b and the first layer 36a placed between the respective second layers 36b, one second layer 36b is placed on the heat transfer target body 10 side, and the other second layer 36b is placed on the heat transfer body 20 side. In addition, the bonding material 31 has entered the gaps between the inorganic fiber particles in each second layer 36b of the inorganic porous body 36 and the gaps between the inorganic fiber particles in the first layer 36a. In another mode, the bonding material 31 may not necessarily have entered the gaps between the inorganic fibers in the first layer 36a of the inorganic porous body 36 and the gaps between the inorganic fibers in each second layer 36b.

In the heat transfer device 9 shown in FIG. 9, the inorganic porous body 36 is unevenly distributed such that, with respect to a plurality of cross-sections C₁ to C₅ extending parallel to the surface of the heat transfer body 20 at equal intervals, the bonding layer 40 includes the first layer 36a having a first proportion as the proportion occupied by the inorganic porous body 36 in the bonding layer 40 and the second layers 36b having a second proportion different from the first proportion as this proportion. In this case, the inorganic porous body 36 is composed of the three layers 36b, 36a, and 36b having different occupancy ratios in the bonding layer 40 to incorporate the advantages of both types of layers therein, and thus can have excellent thermal conductivity and stress relaxation properties.

Moreover, for the cross-sections C₁ and C₅ for which the ratio of the proportion occupied by the inorganic porous body 36 in the bonding layer 40 to the average value of the proportions occupied by the inorganic porous body 36 in the bonding layer 40 in the plurality of cross-sections C₁ to C₅ is the smallest, this ratio is in the range of 0 to 0.5. In this case, the inorganic porous body 36 can be more reliably distributed unevenly in the bonding layer 40.

A production method for such a heat transfer device 9 is similar to the production method for the heat transfer device 7 shown in FIG. 7, and thus the description thereof is omitted.

In the bonding layer 40 and the heat transfer device 9 shown in FIG. 9, the inorganic porous body 36 is unevenly distributed in the bonding layer 40. Specifically, the inorganic porous body 36 is composed of the three layers 36b, 36a, and 36b having different occupancy ratios in the bonding layer 40 to incorporate the advantages of both types of layers therein. Therefore, the bonding layer 40 can have excellent thermal conductivity and stress relaxation properties.

According to the bonding layer 40 and the heat transfer devices 1 to 9 of the present embodiment having the configuration described above, the bonding layer 40 placed on the surface of the heat transfer body 20 has the fiber structure 30 or the inorganic porous body 36 and the bonding material 31, and the fiber structure 30 or the inorganic porous body 36 is unevenly distributed such that, with respect to a plurality of (e.g., five) cross-sections extending parallel to the surface of the heat transfer body 20 at equal intervals, a cross-section where the fiber structure 30 is absent exists, or the bonding layer 40 includes the first layer 36a having a first proportion as the proportion occupied by the inorganic porous body 36 in the bonding layer 40 and the second layer 36b having a second proportion different from the first proportion as this proportion. In this case, while maintaining sufficient thermal conductivity between the heat transfer body 20 and the heat transfer target body 10, problems such as cracking between the heat transfer body 20 and the bonding layer 40 can be prevented from occurring when the heat transfer body 20 undergoes thermal expansion or thermal contraction, and deterioration of the stress relaxation properties of the bonding layer 40 can be prevented.

More specifically, in the bonding layers 40 of the heat transfer devices 1, 2, and 4 to 6 shown in FIG. 1A, FIG. 1B, FIG. 2, and FIG. 4 to FIG. 6, the fiber structure 30 is unevenly distributed such that, with respect to the plurality of (e.g., five) cross-sections extending parallel to the surface of the heat transfer body 20 at equal intervals, a cross-section where the fiber structure 30 is absent exists. In this case, while maintaining sufficient thermal conductivity between the heat transfer body 20 and the heat transfer target body 10, problems such as cracking between the heat transfer body 20 and the bonding layer 40 can be prevented from occurring when the heat transfer body 20 undergoes thermal expansion or thermal contraction. In addition, in the bonding layers 40 of the heat transfer devices 7 to 9 shown in FIG. 7 to FIG. 9, the inorganic porous body 36 is unevenly distributed such that the bonding layer 40 includes the first layer 36a having a first proportion as the proportion occupied by the inorganic porous body 36 in the bonding layer 40 and the second layer 36b having a second proportion different from the first proportion as this proportion. In this case, deterioration of the stress relaxation properties of the bonding layer 40 can be prevented while maintaining sufficient thermal conductivity between the heat transfer body 20 and the heat transfer target body 10.

Moreover, in the bonding layers 40 of the heat transfer devices 1, 2, and 4 to 9 shown in FIG. 1A, FIG. 1B, FIG. 2, and FIG. 4 to FIG. 9, for a cross-section for which the ratio of the proportion occupied by the fiber structure 30 or the inorganic porous body 36 in the bonding layer 40 to the average of these proportions in a plurality of cross-sections is the smallest, this ratio is in the range of 0 to 0.45. In this case, the fiber structure 30 is sufficiently unevenly distributed in the bonding layer 40, and thus, while maintaining sufficient thermal conductivity between the heat transfer body 20 and the heat transfer target body 10, problems such as cracking between the heat transfer body 20 and the bonding layer 40 can be prevented from occurring when the heat transfer body 20 undergoes thermal expansion or thermal contraction, and deterioration of the stress relaxation properties of the bonding layer 40 can be prevented.

Moreover, in the bonding layers 40 of the heat transfer devices 1 to 9 shown in FIG. 1A, FIG. 1B, and FIG. 2 to FIG. 9, the thickness of the bonding layer 40 in the direction orthogonal to the surface of the heat transfer body 20 is 10 µm to 200 µm. Accordingly, the strength of the bonding layer 40 can be sufficiently maintained while maintaining sufficient thermal conductivity between the heat transfer body 20 and the heat transfer target body 10.

Moreover, in the bonding layer 40 of the heat transfer device 1 shown in FIG. 1B, the ratio of the proportion occupied by the fiber structure 30 in contact with the surface of the heat transfer body 20 to the proportion occupied by the fiber structure 30 in the cross-section C₆ located at a thickness position of 5 µm from the surface of the heat transfer body 20, is in the range of 0 to 0.8. In this case, the fiber structure 30 can be prevented from being in a dense state near the surface of the heat transfer body 20, and thus problems such as cracking between the heat transfer body 20 and the bonding layer 40 can be prevented from occurring when the heat transfer body 20 undergoes thermal expansion or thermal contraction.

Moreover, in the bonding layers 40 of the heat transfer devices 1 to 9 shown in FIG. 1A, FIG. 1B, and FIG. 2 to FIG. 9, the occupancy ratio of the fiber structure 30 or the inorganic porous body 36 is 25% to 95%. Accordingly, deterioration of the shape-following properties and cushioning properties of the bonding layer 40 can be prevented.

Moreover, in the heat transfer device 2 shown in FIG. 2, the ratio of the area where the fiber structure 30 is in contact with the heat transfer body 20 to the area where the bonding material 31 is in contact with the heat transfer body 20 is 0.1 to 1.5. In this case, the fiber structure 30 can be prevented from being in a dense state on the surface of the heat transfer body 20, while ensuring sufficient thermal conductivity between the heat transfer body 20 and the bonding layer 40, and thus the heat transfer body 20 and the heat transfer target body 10 can be sufficiently joined by the bonding layer 40.

Moreover, in the heat transfer device 3 shown in FIG. 3, the heat transfer target body 10 is placed on the surface of the bonding layer 40 opposite to the surface of the bonding layer 40 on which the heat transfer body 20 is placed, and the ratio of the area where the fiber structure 30 is in contact with the heat transfer target body 10 to the area where the fiber structure 30 is in contact with the heat transfer body 20 is 0.4 to 2.5. In this case, the bonding layer 40 can exhibit sufficient thermal conductivity, and problems such as cracking between the heat transfer body 20 and the bonding layer 40 and between the heat transfer target body 10 and the bonding layer 40 can be prevented from occurring.

Moreover, the bonding layer 40 has a thermal expansion coefficient of 5 ppm/°C to 25 ppm/°C at 100°C to 200°C.

Moreover, the difference in linear expansion coefficient between the fiber structure 30 or the inorganic porous body 36 and the bonding material 31 at 100°C to 200°C is 0.1 ppm/°C to 15 ppm/°C.

Moreover, in the bonding layers 40 of the heat transfer devices 1 to 9 shown in FIG. 1A, FIG. 1B, and FIG. 2 to FIG. 9, the bonding material 31 may be arranged in the gaps in the fiber structure 30 or the inorganic porous body 36.

Moreover, in the bonding layers 40 of the heat transfer devices 1 to 9 shown in FIG. 1A, FIG. 1B, and FIG. 2 to FIG. 9, among the plurality of cross-sections C₁ to C₅, the bonding material 31 is arranged in the gaps in the fiber structure 30 or the inorganic porous body 36 in one or more or all of the cross-sections where the fiber structure 30 or the inorganic porous body 36 is present.

Moreover, in the bonding layers 40 of the heat transfer devices 1 to 9 shown in FIG. 1A, FIG. 1B, and FIG. 2 to FIG. 9, the ratio of the volume of the bonding material 31 arranged in the gaps in the fiber structure 30 or the inorganic porous body 36 to the volume of the bonding material 31 in the bonding layer 40 is 0% to 80%.

Moreover, the bonding material 31 arranged in the gaps in the fiber structure 30 or the inorganic porous body 36 is thermally fused to the fiber structure 30 or the inorganic porous body 36. In this case, the connection between the bonding material 31 and the fiber structure 30 or the inorganic porous body 36 can be made stronger.

Moreover, the fiber structure 30 or the inorganic porous body 36 and the heat transfer body 20 may or may not be joined to each other as long as they are thermally or electrically connected. Here, the connection between the fiber structure 30 or the inorganic porous body 36 and the heat transfer body 20 may be direct or indirect. Examples of the direct connection include joining by sintering, which includes the inorganic porous body 36 and the heat transfer body 20 being joined through alloys or materials. Examples of the indirect connection include joining using a resin material or metal paste. When the fiber structure 30 or the inorganic porous body 36 and the heat transfer body 20 are joined to each other, the connection between the fiber structure 30 or the inorganic porous body 36 and the heat transfer body 20 can be made stronger. On the other hand, when the fiber structure 30 or the inorganic porous body 36 and the heat transfer body 20 are not joined to each other, problems such as cracking between the heat transfer body 20 and the bonding layer 40 can be prevented from occurring when the heat transfer body 20 undergoes thermal expansion or thermal contraction, and deterioration of the stress relaxation properties of the bonding layer 40 can be prevented.

Moreover, the inorganic porous body includes inorganic fibers. That is, as the inorganic porous body, the fiber structure 30 as shown in FIG. 1A, FIG. 1B, and FIG. 2 to FIG. 6 may be used.

Moreover, the inorganic fibers include copper fibers. In this case, the thermal conductivity of the inorganic porous body can be improved.

The bonding layer, the heat transfer device, and the production method for the bonding layer according to the present invention are not limited to the embodiment described above and various modifications can be made.

For example, the surface of the heat transfer body 20 is not limited to a flat surface. In another embodiment, the surface of the heat transfer body 20 may be curved. In this case, the bonding layer 40 is placed on the curved surface of the heat transfer body 20. In addition, in this case, the plurality of cross-sections extending parallel to the surface of the heat transfer body 20 at equal intervals also become curved surfaces.

Moreover, the inorganic porous body included in the bonding layer is not limited to the fiber structure or the body having a structure in which fine inorganic fiber particles such as fine metal fiber particles are densely packed. As the inorganic porous body, a body having another structure can be used as long as the body has many pores.

### EXAMPLES

Hereinafter, the present disclosure will be described in more detail using Examples and Comparative Example.

### (Bonding materials)

The following bonding materials 1 to 5 were prepared as the bonding material.
Bonding Material 1: Sn-1Ag-0.5Cu (melting point: 227°C, linear expansion coefficient: 20.9 ppm/°C)
Bonding Material 2: Sn-5Sb (melting point: 243°C, linear expansion coefficient: 22.8 ppm/°C)
Bonding Material 3: Ag (melting point: 962°C, linear expansion coefficient: 19.2 ppm/°C)
Bonding Material 4: Cu (melting point: 1083°C, linear expansion coefficient: 18.2 ppm/°C)
Bonding Material 5: Nano Ag paste (electric conductive adhesive TK Paste, manufactured by KAKEN TECH CO., LTD.)

### (Evaluation samples)

For Example 1, an evaluation sample was prepared using the configuration shown in Table 1. Specifically, the bonding material 1 was melted on the surface of a C1100 copper plate (50 mm width × 50 mm length × 2 mm thickness) on a hot plate set to 250°C, a copper fiber structure was placed on the bonding material 1, and further, the molten bonding material 1 was applied over the copper fiber structure to impregnate the gaps between copper fibers with the bonding material and was cooled and solidified. Then, an alumina plate (50 mm width × 50 mm length × 2 mm thickness) was placed on the bonding material 1, and the bonding material 1 was re-melted on a hot plate set to 250°C and was cooled and solidified to obtain a test piece. The test piece was then cut to a size of 30 mm width × 30 mm length to obtain the evaluation sample.

For Examples 2, 5 to 18, and 24 to 29, evaluation samples were prepared in the same manner as Example 1 using the configurations shown in Tables 1 to 4 and Table 6.

For Examples 3 and 4, evaluation samples were prepared in the same manner as Example 1 using the configurations shown in Table 1, except that the temperature for melting the bonding material was 1100°C (electric furnace).

For Comparative Example 1, an evaluation sample was prepared using the configuration shown in Table 4. Specifically, copper powder (low-temperature sinterable copper powder CH-0200L1, manufactured by MITSUI KINZOKU COMPANY, LIMITED) was dispersed in the heated and melted bonding material 1 to obtain a bonding material 7. The bonding material 7 was melted on the surface of a C1100 copper plate (50 mm width × 50 mm length × 2 mm thickness) on a hot plate set to 250°C, and then an alumina plate (50 mm width × 50 mm length × 2 mm thickness) was placed on the bonding material 7 and was cooled and solidified to obtain a test piece. The test piece was then cut to a size of 30 mm width × 30 mm length to obtain the evaluation sample.

For Example 19, an evaluation sample was prepared using the configuration shown in Table 5. Specifically, a copper fiber structure was placed on the surface of a C1100 copper plate (50 mm width × 50 mm length × 1 mm thickness), and further, the bonding material 5 was applied over the copper fiber structure to impregnate the gaps between copper fibers with the bonding material. Then, an alumina plate (50 mm width × 50 mm length × 1 mm thickness) was placed on the bonding material 5. Next, the copper plate and the copper fiber structure were sintered using an electric furnace set to 1100°C, while simultaneously vaporizing the organic component of the bonding material 5, to obtain each test piece. The test piece was cut to a size of 30 mm width × 30 mm length to obtain the evaluation sample.

For Examples 20 to 23 and 30 to 35, evaluation samples were prepared in the same manner as Example 19 using the configurations shown in Tables 5 and 7.

**[Table 1]**

| | | | Example 1 | Example 2 | Example 3 | Example 4 | Example 5 |
|---|---|---|---|---|---|---|---|
| Fiber structure | Composition | - | Copper fiber | Copper fiber | Copper fiber | Copper fiber | Copper fiber |
| | Diameter | µm | 12.5 | 12.5 | 12.5 | 12.5 | 7.5 |
| | Length | mm | 0.2 | 0.2 | 0.2 | 0.2 | 0.2 |
| | Occupancy ratio | % | 55 | 55 | 55 | 55 | 55 |
| | Linear expansion coefficient at 100°C to 200°C | ppm/°C | 18 | 18 | 18 | 18 | 18 |
| Bonding material | Composition | - | Bonding material 1 | Bonding material 3 | Bonding material 4 | Bonding material 2 | Bonding material 1 |
| | Linear expansion coefficient at 100°C to 200°C | ppm/°C | 20.9 | 19.2 | 18.2 | 22.8 | 20.9 |
| Bonding layer | Thickness | µm | 25 | 25 | 25 | 25 | 12.5 |
| | (A) Area of bonding layer | mm² | 169 | 169 | 169 | 169 | 169 |
| | (B) Area where fiber structure is in contact with heat transfer body | mm² | 51.1 | 51.1 | 51.1 | 51.1 | 51.1 |
| | (C) Area where bonding material is in contact with heat transfer body | mm² | 117.9 | 117.9 | 117.9 | 117.9 | 117.9 |
| | (D) Area where fiber structure is in contact with heat transfer target body | mm² | 40.9 | 40.9 | 40.9 | 40.9 | 40.9 |
| Bonding layer | (E) Area of fiber structure in cross-section at thickness position of 5 µm from surface of heat transfer body | mm² | 74.4 | 74.4 | 74.4 | 74.4 | 74.4 |
| | (F) Proportion in cross-section in which proportion of fiber structure is smallest/average value of proportions occupied by fiber structure in bonding layer | | 0.20 | 0.22 | 0.19 | 0.20 | 0.20 |
| | (B)/(E) | | 0.69 | 0.69 | 0.69 | 0.69 | 0.69 |
| | (B)/(C) | | 0.43 | 0.43 | 0.43 | 0.43 | 0.43 |
| | (D)/(B) | | 0.80 | 0.80 | 0.80 | 0.80 | 0.80 |
| | Linear expansion coefficient of bonding layer at 100°C to 200°C | ppm/°C | 17 | 17 | 16 | 19 | 17 |
| | Linear expansion coefficient difference between fiber structure and bonding material at 100°C to 200°C | ppm/°C | 1 | 1 | 2 | 1 | 1 |
| Cooling member | Composition | - | Copper | Copper | Copper | Copper | Copper |
| Thermal cycling test | | | A+ | A+ | A+ | A+ | B |
| Heat transfer properties | | | A | A | A | A | A |
| Overall evaluation | | | 9 | 9 | 9 | 9 | 6 |

**[Table 2]**

| | | | Example 6 | Example 7 | Example 8 | Example 9 | Example 10 |
|---|---|---|---|---|---|---|---|
| Fiber structure | Composition | - | Copper fiber | Copper fiber | Copper fiber | Copper fiber | Copper fiber |
| | Diameter | µm | 7.5 | 12.5 | 12.5 | 12.5 | 12.5 |
| | Length | mm | 0.2 | 0.2 | 0.2 | 0.2 | 0.2 |
| | Occupancy ratio | % | 55 | 35 | 80 | 55 | 55 |
| | Linear expansion coefficient at 100°C to 200°C | ppm/°C | 18 | 18 | 18 | 18 | 18 |
| Bonding material | Composition | - | Bonding material 1 | Bonding material 1 | Bonding material 1 | Bonding material 1 | Bonding material 1 |
| | Linear expansion coefficient at 100°C to 200°C | ppm/°C | 20.9 | 20.9 | 20.9 | 20.9 | 20.9 |
| Bonding layer | Thickness | µm | 75 | 25 | 25 | 25 | 25 |
| | (A) Area of bonding layer | mm² | 169 | 169 | 169 | 169 | 169 |
| | (B) Area where fiber structure is in contact with heat transfer body | mm² | 51.1 | 32.5 | 79.0 | 29.3 | 53.2 |
| | (C) Area where bonding material is in contact with heat transfer body | mm² | 117.9 | 136.5 | 90.0 | 139.7 | 115.8 |
| | (D) Area where fiber structure is in contact with heat transfer target body | mm² | 40.9 | 30.3 | 70.6 | 48.2 | 22.3 |
| Bonding layer | (E) Area of fiber structure in cross-section at thickness position of 5 µm from surface of heat transfer body | mm² | 74.4 | 44.5 | 102.3 | 74.4 | 74.4 |
| | (F) Proportion in cross-section in which proportion of fiber structure is smallest/average value of proportions occupied by fiber structure in bonding layer | | 0.21 | 0.33 | 0.16 | 0.12 | 0.24 |
| | (B)/(E) | | 0.69 | 0.73 | 0.77 | 0.39 | 0.72 |
| | (B)/(C) | | 0.43 | 0.24 | 0.88 | 0.21 | 0.46 |
| | (D)/(B) | | 0.80 | 0.93 | 0.89 | 1.65 | 0.42 |
| | Linear expansion coefficient of bonding layer at 100°C to 200°C | ppm/°C | 17 | 17 | 17 | 17 | 17 |
| | Linear expansion coefficient difference between fiber structure and bonding material at 100°C to 200°C | ppm/°C | 1 | 1 | 1 | 1 | 1 |
| Cooling member | Composition | - | Copper | Copper | Copper | Copper | Copper |
| Thermal cycling test | | | A+ | A+ | B | A+ | B |
| Heat transfer properties | | | B | C | A | B | A |
| Overall evaluation | | | 7 | 6 | 6 | 7 | 6 |

**[Table 3]**

| | | | Example 11 | Example 12 | Example 13 | Example 14 | Example 15 |
|---|---|---|---|---|---|---|---|
| Fiber structure | Composition | - | Tungsten fiber | Copper fiber | Copper fiber | Copper fiber | Copper fiber |
| | Diameter | µm | 12.5 | 12.5 | 12.5 | 3.5 | 12.5 |
| | Length | mm | 0.2 | 0.2 | 0.2 | 0.2 | 0.2 |
| | Occupancy ratio | % | 55 | 25 | 90 | 55 | 55 |
| | Linear expansion coefficient at 100°C to 200°C | ppm/°C | 3 | 18 | 18 | 18 | 18 |
| Bonding material | Composition | - | Bonding material 1 | Bonding material 1 | Bonding material 1 | Bonding material 1 | Bonding material 1 |
| | Linear expansion coefficient at 100°C to 200°C | ppm/°C | 20.9 | 20.9 | 20.9 | 20.9 | 20.9 |
| Bonding layer | Thickness | µm | 25 | 25 | 25 | 7.5 | 150 |
| | (A) Area of bonding layer | mm² | 169 | 169 | 169 | 169 | 169 |
| | (B) Area where fiber structure is in contact with heat transfer body | mm² | 51.1 | 23.2 | 98.0 | 51.1 | 51.1 |
| | (C) Area where bonding material is in contact with heat transfer body | mm² | 117.9 | 145.8 | 71.0 | 117.9 | 117.9 |
| | (D) Area where fiber structure is in contact with heat transfer target body | mm² | 40.9 | 21.4 | 73.2 | 40.9 | 40.9 |
| Bonding layer | (E) Area of fiber structure in cross-section at thickness position of 5 µm from surface of heat transfer body | mm² | 74.4 | 39.5 | 113.5 | 74.4 | 74.4 |
| | (F) Proportion in cross-section in which proportion of fiber structure is smallest/average value of proportions occupied by fiber structure in bonding layer | | 0.21 | 0.45 | 0.07 | 0.20 | 0.21 |
| | (B)/(E) | | 0.69 | 0.59 | 0.86 | 0.69 | 0.69 |
| | (B)/(C) | | 0.43 | 0.16 | 1.38 | 0.43 | 0.43 |
| | (D)/(B) | | 0.80 | 0.92 | 0.75 | 0.80 | 0.80 |
| | Linear expansion coefficient of bonding layer at 100°C to 200°C | ppm/°C | 17 | 17 | 17 | 17 | 17 |
| | Linear expansion coefficient difference between fiber structure and bonding material at 100°C to 200°C | ppm/°C | 14 | 1 | 1 | 1 | 1 |
| Cooling member | Composition | - | Copper | Copper | Copper | Copper | Copper |
| Thermal cycling test | | | A | A+ | C | C | A+ |
| Heat transfer properties | | | A | D | A | A | C |
| Overall evaluation | | | 8 | 4 | 5 | 5 | 6 |

**[Table 4]**

| | | | Example 16 | Example 17 | Example 18 | Comparative Example 1 |
|---|---|---|---|---|---|---|
| Fiber structure | Composition | - | Copper fiber | Copper fiber | Copper fiber | Copper powder |
| | Diameter | µm | 12.5 | 12.5 | 12.5 | 0.2 |
| | Length | mm | 0.2 | 0.2 | 0.2 | - |
| | Occupancy ratio | % | 55 | 55 | 55 | 72 |
| | Linear expansion coefficient at 100°C to 200°C | ppm/°C | 18 | 18 | 18 | 18 |
| Bonding material | Composition | - | Bonding material 1 | Bonding material 1 | Bonding material 1 | Bonding material 1 |
| | Linear expansion coefficient at 100°C to 200°C | ppm/°C | 20.9 | 20.9 | 20.9 | 20.9 |
| Bonding layer | Thickness | µm | 25 | 25 | 25 | 25 |
| | (A) Area of bonding layer | mm² | 169 | 169 | 169 | 169 |
| | (B) Area where fiber structure is in contact with heat transfer body | mm² | 50.5 | 18.3 | 8.3 | 48.2 |
| | (C) Area where bonding material is in contact with heat transfer body | mm² | 118.5 | 150.7 | 160.7 | 120.8 |
| | (D) Area where fiber structure is in contact with heat transfer target body | mm² | 10.1 | 51.1 | 6.6 | 48.2 |
| Bonding layer | (E) Area of fiber structure in cross-section at thickness position of 5 µm from surface of heat transfer body | mm² | 74.4 | 74.4 | 74.4 | 48.2 |
| | (F) Proportion in cross-section in which proportion of fiber structure is smallest/average value of proportions occupied by fiber structure in bonding layer | | 0.22 | 0.22 | 0.20 | 0.2 |
| | (B)/(E) | | 0.68 | 0.25 | 0.11 | 1.00 |
| | (B)/(C) | | 0.43 | 0.12 | 0.05 | 0.40 |
| | (D)/(B) | | 0.20 | 2.79 | 0.80 | 100 |
| | Linear expansion coefficient of bonding layer at 100°C to 200°C | ppm/°C | 17 | 17 | 17 | 17 |
| | Linear expansion coefficient difference between fiber structure and bonding material at 100°C to 200°C | ppm/°C | 1 | 1 | 1 | 1 |
| Cooling member | Composition | - | Copper | Copper | Copper | Copper |
| Thermal cycling test | | | A+ | A+ | A | D |
| Heat transfer properties | | | B | B | B | B |
| Overall evaluation | | | 7 | 7 | 6 | 1 |

**[Table 5]**

| | | | Example 19 | Example 20 | Example 21 | Example 22 | Example 23 |
|---|---|---|---|---|---|---|---|
| Fiber structure | Composition | - | Copper fiber | Copper fiber | Copper fiber | Copper fiber | Copper fiber |
| | Diameter | µm | 18.5 | 18.5 | 18.5 | 18.5 | 18.5 |
| | Length | mm | 3.0 | 3.0 | 3.0 | 3.0 | 3.0 |
| | Occupancy ratio | % | 50 | 50 | 50 | 50 | 50 |
| | Linear expansion coefficient at 100°C to 200°C | ppm/°C | 18 | 18 | 18 | 18 | 18 |
| Bonding material | Composition | - | Bonding material 5 | Bonding material 5 | Bonding material 5 | Bonding material 5 | Bonding material 5 |
| | Linear expansion coefficient at 100°C to 200°C | ppm/°C | 19.3 | 19.3 | 19.3 | 19.3 | 19.3 |
| Bonding layer | Thickness | µm | 100 | 100 | 100 | 100 | 100 |
| | Impregnation ratio of inorganic porous body with bonding material | % | 0 | 20 | 40 | 80 | 100 |
| | (A) Area of bonding layer | mm² | 169 | 169 | 169 | 169 | 169 |
| | Area ratio occupied by inorganic porous body on bonding layer surface in contact with heat transfer body surface | % | 30.3 | 30.3 | 30.3 | 30.3 | 30.3 |
| | (B) Area where fiber structure is in contact with heat transfer body | mm² | 51.1 | 51.1 | 51.1 | 51.1 | 51.1 |
| Bonding layer | (C) Area where bonding material is in contact with heat transfer body | mm² | 117.9 | 117.9 | 117.9 | 117.9 | 117.9 |
| | (F) Proportion in cross-section in which proportion of fiber structure is smallest/average value of proportions occupied by fiber structure in bonding layer | | 0.0 | 0.0 | 0.0 | 0.0 | 0.4 |
| | Linear expansion coefficient of bonding layer at 100°C to 200°C | ppm/°C | 17 | 17 | 17 | 17 | 17 |
| | Linear expansion coefficient difference between fiber structure and bonding material at 100°C to 200°C | ppm/°C | 1 | 1 | 1 | 1 | 1 |
| Cooling member | Composition | - | Copper | Copper | Copper | Copper | Copper |
| Thermal cycling test | | | A+ | A | A | B | C |
| Heat transfer properties | | | C | B | A | A | A |
| Overall evaluation | | | 6 | 6 | 8 | 6 | 5 |

**[Table 6]**

| | | | Example 24 | Example 25 | Example 26 | Example 27 | Example 28 | Example 29 |
|---|---|---|---|---|---|---|---|---|
| Fiber structure | Composition | - | Copper fiber | Copper fiber | Copper fiber | Copper fiber | Copper fiber | Copper fiber |
| | Diameter | µm | 7.5 | 30 | 50 | 80 | 110 | 140 |
| | Length | mm | 0.05 | 0.2 | 0.2 | 0.2 | 0.2 | 0.2 |
| | Occupancy ratio | % | 55 | 52 | 58 | 50 | 48 | 49 |
| | Linear expansion coefficient at 100°C to 200°C | ppm/°C | 18 | 18 | 18 | 18 | 18 | 18 |
| Bonding material | Composition | - | Bonding material 1 | Bonding material 1 | Bonding material 1 | Bonding material 1 | Bonding material 1 | Bonding material 1 |
| | Linear expansion coefficient at 100°C to 200°C | ppm/°C | 20.9 | 20.9 | 20.9 | 20.9 | 20.9 | 20.9 |
| Bonding layer | Thickness | µm | 75 | 75 | 85 | 120 | 190 | 270 |
| | (A) Area of bonding layer | mm² | 169 | 169 | 169 | 169 | 169 | 169 |
| | (B) Area where fiber structure is in contact with heat transfer body | mm² | 55.5 | 46.6 | 53.2 | 51.7 | 47.0 | 45.5 |
| | (C) Area where bonding material is in contact with heat transfer body | mm² | 113.5 | 122.4 | 115.8 | 117.3 | 122.0 | 123.5 |
| | (D) Area where fiber structure is in contact with heat transfer target body | mm² | 41.2 | 43.7 | 39.0 | 40.8 | 37.8 | 41.1 |
| Bonding layer | (E) Area of fiber structure in cross-section at thickness position of 5 µm from surface of heat transfer body | mm² | 57.8 | 55.7 | 63.1 | 60.8 | 61.1 | 58.9 |
| | (F) Proportion in cross-section in which proportion of fiber structure is smallest/average value of proportions occupied by fiber structure in bonding layer | | 0.21 | 0.21 | 0.21 | 0.21 | 0.21 | 0.21 |
| | (B)/(E) | | 0.96 | 0.84 | 0.84 | 0.85 | 0.77 | 0.77 |
| | (B)/(C) | | 0.49 | 0.38 | 0.46 | 0.44 | 0.39 | 0.37 |
| | (D)/(B) | | 0.74 | 0.94 | 0.73 | 0.79 | 0.80 | 0.90 |
| | Linear expansion coefficient of bonding layer at 100°C to 200°C | ppm/°C | 17 | 17 | 17 | 17 | 17 | 17 |
| | Linear expansion coefficient difference between fiber structure and bonding material at 100°C to 200°C | ppm/°C | 1 | 1 | 1 | 1 | 1 | 1 |
| Cooling member | Composition | - | Copper | Copper | Copper | Copper | Copper | Copper |
| Thermal cycling test | | | A+ | A | A | B | C | D |
| Heat transfer properties | | | C | A | A | A | A | A+ |
| Overall evaluation | | | 6 | 8 | 8 | 6 | 5 | 4 |

**[Table 7]**

| | | | Example 30 | Example 31 | Example 32 | Example 33 | Example 34 | Example 35 |
|---|---|---|---|---|---|---|---|---|
| Fiber structure | Composition | - | Copper fiber | Copper fiber | Copper fiber | Copper fiber | Copper fiber | Copper fiber |
| | Diameter | µm | 18.5 | 30 | 50 | 80 | 110 | 140 |
| | Length | mm | 6 | 3 | 3 | 3 | 3 | 3 |
| | Occupancy ratio | % | 50 | 50 | 50 | 50 | 50 | 50 |
| | Linear expansion coefficient at 100°C to 200°C | ppm/°C | 18 | 18 | 18 | 18 | 18 | 18 |
| Bonding material | Composition | - | Bonding material 5 | Bonding material 5 | Bonding material 5 | Bonding material 5 | Bonding material 5 | Bonding material 5 |
| | Linear expansion coefficient at 100°C to 200°C | ppm/°C | 19.3 | 19.3 | 19.3 | 19.3 | 19.3 | 19.3 |
| Bonding layer | Thickness | µm | 100 | 100 | 100 | 150 | 190 | 270 |
| | (A) Area of bonding layer | mm² | 20 | 20 | 20 | 20 | 20 | 20 |
| | (B) Area where fiber structure is in contact with heat transfer body | mm² | 169 | 169 | 169 | 169 | 169 | 169 |
| | (C) Area where bonding material is in contact with heat transfer body | mm² | 30.3 | 30.3 | 30.3 | 30.3 | 30.3 | 30.3 |
| | (D) Area where fiber structure is in contact with heat transfer target body | mm² | 48.2 | 50.1 | 50.7 | 48.8 | 49.1 | 50.1 |

| | | | Example 30 | Example 31 | Example 32 | Example 33 | Example 34 | Example 35 |
|---|---|---|---|---|---|---|---|---|
| Bonding layer | (E) Area of fiber structure in cross-section at thickness position of 5 µm from surface of heat transfer body | mm² | 120.8 | 118.9 | 118.3 | 120.2 | 119.9 | 118.9 |
| | (F) Proportion in cross-section in which proportion of fiber structure is smallest/average value of proportions occupied by fiber structure in bonding layer | | 0.0 | 0.0 | 0.0 | 0.0 | 0.0 | 0.0 |
| | Linear expansion coefficient of bonding layer at 100°C to 200°C | ppm/°C | 17 | 17 | 17 | 17 | 17 | 17 |
| | Linear expansion coefficient difference between fiber structure and bonding material at 100°C to 200°C | ppm/°C | 1 | 1 | 1 | 1 | 1 | 1 |
| Cooling member | Composition | - | Copper | Copper | Copper | Copper | Copper | Copper |
| Thermal cycling test | | | B | B | B | B | C | D |
| Heat transfer properties | | | B | A+ | A+ | A+ | A+ | A+ |
| Overall evaluation | | | 4 | 7 | 7 | 7 | 6 | 4 |

### <Evaluation>

### (Evaluation of thermal cycling test)

For Examples 1 to 35 and Comparative Example 1, each evaluation sample was placed in a thermostatic chamber set to -55°C and allowed to stand for 30 minutes. Then, the temperature was raised to 150°C at a heating rate of 10°C/min and the evaluation sample was allowed to stand for 30 minutes. Then, the temperature was lowered to -55°C at a cooling rate of 10°C/min and the evaluation sample was allowed to stand for 30 minutes. Then, the heating and cooling steps were repeated under the same conditions to perform a thermal cycling test. Evaluation was conducted according to the following criteria.
A+: No cracks and delamination were observed after 500 cycles.
A: Cracks and delamination were observed after 400 cycles or more but less than 500 cycles.
B: Cracks and delamination were observed after 300 cycles or more but less than 400 cycles.
C: Cracks and delamination were observed after 200 cycles or more but less than 300 cycles.
D: Cracks and delamination were observed in less than 200 cycles.

### (Evaluation of heat transfer properties)

For Examples 1 to 35 and Comparative Example 1, measurement was performed using the temperature wave analysis method. Specifically, only the bonding layer of each evaluation sample was cut into a disk shape with a diameter of 10 mm, and the thermal conductivity was measured using a thermal diffusivity and thermal conductivity measuring apparatus (ai-Phase Mobile M3, manufactured by ai-Phase Co., Ltd.). Evaluation was conducted according to the following criteria.
A: Thermal conductivity was 200 W/m·K or more.
B: Thermal conductivity was 100 W/m·K or more but less than 200 W/m·K.
C: Thermal conductivity was 50 W/m·K or more but less than 100 W/m·K.
D: Thermal conductivity was less than 50 W/m·K.

### (Overall evaluation)

Each evaluation result was converted into a numerical value according to the following criteria, and the total value of the numerical values for (Evaluation of thermal cycling test) and (Evaluation of heat transfer properties) was regarded as an overall evaluation. Here, a larger total value indicates a better evaluation result, and a smaller total value indicates a poorer evaluation result. As shown in Table 1 to Table 5 above, Examples 1 to 35 had overall evaluations of 4 to 9, and satisfactory results were obtained for both thermal cycling test and heat transfer properties. In contrast, Comparative Example 1 had an overall evaluation of 1, and good evaluation was not obtained; for example, particularly in the thermal cycling test, cracks and delamination were observed in less than 200 cycles. Thus, it was found that using copper fibers instead of copper powder as the fiber structure can suppress the occurrence of problems such as cracking between the heat transfer body and the bonding layer.
A+: +5
A: +4
B: +2
C: +1
D: -1

## Claims

1. A bonding layer comprising:
an inorganic porous body; and
a bonding material, the bonding layer being a layer that is to be placed on a surface of a heat transfer body, wherein
the inorganic porous body is unevenly distributed such that, with respect to a plurality of cross-sections extending parallel to the surface of the heat transfer body at equal intervals, a cross-section where the inorganic porous body is absent exists, or the bonding layer includes a first layer having a first proportion as a proportion occupied by the inorganic porous body in the bonding layer and a second layer having a second proportion different from the first proportion as said proportion.

2. The bonding layer according to claim 1, wherein, for a cross-section for which a ratio of the proportion to an average value of proportions occupied by the inorganic porous body in the bonding layer in the plurality of cross-sections is the smallest, said ratio is in a range of 0 to 0.5.

3. The bonding layer according to claim 1, wherein a thickness of the bonding layer in a direction orthogonal to the surface of the heat transfer body is 10 µm to 200 µm.

4. The bonding layer according to any one of claims 1 to 3, wherein a ratio of the proportion in the cross-section where the inorganic porous body is in contact with the heat transfer body to the proportion in the cross-section located at a thickness position of 5 µm from the surface of the heat transfer body is in a range of 0 to 0.8.

5. The bonding layer according to claim 1, wherein an occupancy ratio of the inorganic porous body is 25% to 95%.

6. The bonding layer according to claim 1, wherein a ratio of an area where the inorganic porous body is in contact with the heat transfer body to an area where the bonding material is in contact with the heat transfer body is 0.1 to 1.5.

7. The bonding layer according to claim 1, wherein
a heat transfer target body is placed on a surface of the bonding layer opposite to a surface of the bonding layer on which the heat transfer body is placed, and
a ratio of an area where the inorganic porous body is in contact with the heat transfer target body to an area where the inorganic porous body is in contact with the heat transfer body is 0.4 to 2.5.

8. The bonding layer according to claim 1, having a thermal expansion coefficient of 5 ppm/°C to 25 ppm/°C at 100°C to 200°C.

9. The bonding layer according to claim 1, wherein a difference in linear expansion coefficient between the inorganic porous body and the bonding material at 100°C to 200°C is 0.1 ppm/°C to 15 ppm/°C.

10. The bonding layer according to claim 1, wherein the bonding material is arranged in gaps in the inorganic porous body.

11. The bonding layer according to claim 1, wherein the bonding material is arranged in gaps in the inorganic porous body in one or more or all of the cross-sections where the inorganic porous body is present among the plurality of cross-sections.

12. The bonding layer according to claim 11, wherein a ratio of a volume of the bonding material arranged in the gaps in the inorganic porous body to a volume of the bonding material in the bonding layer is 0% to 80%.

13. The bonding layer according to claim 11, wherein the bonding material arranged in the gaps in the inorganic porous body is sintered to the inorganic porous body.

14. The bonding layer according to claim 1, wherein the inorganic porous body includes inorganic fibers.

15. The bonding layer according to claim 14, wherein the inorganic fibers include copper fibers.

16. A heat transfer device comprising:
a heat transfer body; and
a bonding layer placed on a surface of the heat transfer body, wherein
the bonding layer includes
an inorganic porous body, and
a bonding material, and
the inorganic porous body is unevenly distributed such that, with respect to a plurality of cross-sections extending parallel to the surface of the heat transfer body at equal intervals, a cross-section where the inorganic porous body is absent exists, or the bonding layer includes a first layer having a first proportion as a proportion occupied by the inorganic porous body in the bonding layer and a second layer having a second proportion different from the first proportion as said proportion.

17. A production method for a bonding layer to be placed on a surface of a heat transfer body, the production method comprising the steps of:
placing an inorganic porous body on the surface of the heat transfer body;
melting a bonding material and supplying the molten bonding material to a surface of the inorganic porous body; and
cooling the bonding material.

18. The production method for the bonding layer according to claim 17, wherein the step of melting the bonding material and supplying the molten bonding material to the surface of the inorganic porous body includes applying the molten bonding material to the surface of the inorganic porous body.

19. The production method for the bonding layer according to claim 17, wherein the step of melting the bonding material and supplying the molten bonding material to the surface of the inorganic porous body includes impregnating an interior of the inorganic porous body with the molten bonding material.

20. The production method for the bonding layer according to claim 17, further comprising placing another bonding material different from the bonding material, on a surface of the cooled bonding material after the step of cooling the bonding material.

21. A production method for a bonding layer to be placed on a surface of a heat transfer body, the production method comprising the steps of:
placing a bonding material on the bonding layer;
placing an inorganic porous body on a surface of the bonding material;
melting another bonding material different from the bonding material and supplying the molten other bonding material to a surface of the inorganic porous body; and
cooling the other bonding material.
